# EUROPEAN PATENT APPLICATION

(11) **EP 2 253 919 A2**
(43) Date of publication of application: **24.11.2010**
(21) Application number: 10163003.6
(22) Date of filing: 17.05.2010
(51) Int. Cl.: F28D 15/04, B22F 1/02, H01L 23/427

(54) **High Performance Heat Transfer Device, Methods Of Manufacture Thereof And Articles Comprising The Same**

(30) Priority: 22.05.2009 US 470553
(71) Applicant: General Electric Company, Schenectady, NY 12345 (US)
(72) Inventor: Rush, Brian Magann, Niskayuna, NY 12309 (US); De Bock, Hendrik Pieter Jacobus, Clifton Park, NY 12065 (US); Deng, Tao, Clifton Park, NY 12065 (US); Russ, Boris Alexander, Niskayuna, NY 12309 (US); Varanasi, Kripa Kiran, Cambridge, MA 02142 (US); Weaver Jr., Stanton Earl, Northville, NY 12134 (US)
(74) Representative: Illingworth-Law, William Illingworth

(57) **Abstract**

Disclosed herein is an heat transfer device (100) comprising a shell (20); the shell (20) being an enclosure that prevents matter from within the shell (20) from being exchanged with matter outside the shell (20); the shell (20) having an outer surface and an inner surface; and a porous layer disposed on the inner surface of the shell (20); the porous layer having a thickness effective to enclose a region (24) between opposing faces (21 and 23); the region (24) providing a passage for the transport of a fluid; the porous layer having a thermal conductivity of about 0.1 to about 2000 watts per meter-Kelvin and a mass flow rate of about 10⁻⁹ to about 10⁻⁴ kilograms per second.

## Description

### BACKGROUND OF THE INVENTION

This disclosure relates to a high performance heat transfer device, methods of manufacture thereof and to articles comprising the same.

When a fluid is contained in a vessel under saturation conditions, addition of heat leads to evaporation or boiling. This evaporation causes an increase in vapor pressure, which drives the flow of vapor to the cooler areas of the system, hereby referred to as the condenser region. At the condenser region, heat is rejected as vapor condenses to a liquid. Porous media capillaries or gravity can be used to transport liquid back to the evaporation area. This mechanism of two-phase heat transfer is often employed, as it is very efficient at moving large amounts of heat at minimal temperature gradient. A porous structure can also enhance heat transfer in the evaporation region as it increases the effective evaporation area and supplies nucleation sites for vapor bubbles to generate from.

The capillary action of a porous medium relates to its effective pore size distribution, which relates to its particle size. Smaller pores enable structures with higher capillary action. Permeability of a porous medium relates to the rate at which a fluid can be transported through the medium given a pressure difference across the system. In order to achieve high permeability, large pore sizes are desired. In applications such as, for example, evaporator sections for heat pipes, where both heat transfer and capillary-driven mass transfer are simultaneously desired, a trade-off is required to between capillary action and permeability of the porous medium. This trade-off can be further complicated when applications require that the transport section function under increasing gravitational forces. This requires decreased pore sizes, which then limit the heat transfer.

### BRIEF DESCRIPTION OF THE INVENTION

Disclosed herein is a heat transfer device comprising a shell; the shell being an enclosure that prevents matter from within the shell from being exchanged with matter outside the shell; the shell having an outer surface and an inner surface; and a porous layer disposed on the inner surface of the shell; the porous layer having a thickness effective to enclose a region between opposing faces; the region providing a passage for the transport of a fluid; the porous layer having a thermal conductivity of about 0.1 to about 2000 watts per meter-Kelvin and a mass flow rate of about 10⁻⁹ to about 10⁻⁴ kilograms per second.

Disclosed herein too is a method comprising disposing a slurry upon a substrate; the slurry comprising a liquid and about 0.0001 to about 60% volume percent of nanoparticles, based upon the total volume of the slurry; evaporating the liquid from the substrate to form a porous layer having a thickness of about 10 nanometers to about 10,000,000 nanometers upon the substrate; and forming the substrate into a shell; the shell being an enclosure that prevents matter from within the shell from being exchanged with matter outside the shell; the porous layer being disposed upon an inner surface of the shell.

Disclosed herein is a method comprising contacting a first end of a heat transfer device with a source of heat; the heat transfer device comprising a shell; the shell being an enclosure that prevents matter from within the shell from being exchanged with matter outside the shell; the shell having an outer surface and an inner surface; and a porous layer disposed on the inner surface of the shell; the porous layer having a thickness effective to enclose a region between opposing faces; the region providing a passage for the transport of a fluid; the porous layer having a thermal conductivity of about 0.1 to about 2000 watts per meter-Kelvin and a mass flow rate of about 10⁻⁹ to about 10⁻⁴ kilograms per second; evaporating a fluid that is disposed in the porous layer; and promoting a flow of the fluid to a second end of the heat transfer device; the second end of the heat transfer device contacting a heat sink.

### BRIEF DESCRIPTION OF THE DRAWINGS

Figure 1 is an exemplary schematic drawing depicting a heat transfer device where heat is input at the first end and extracted from the heat transfer device at the second end;
Figure 2(a), (b), (c), (d) and (e) depicts various combinations of particles in the porous layer of the first section. The exemplary views depicted in the Figures 2(a), (b), (c), (d) and (e) are expanded views of the section C-C' taken from the Figure 1. These views are cross-sectional views taken in a direction perpendicular to the length "1" of the heat transfer device at A-A';
Figure 3 depicts a unit cell formed by the particles comprising the porous layer;
Figure 4 is a graph that depicts the thin film area per unit cell at a contact angle of 10 degrees and a fill factor of 50%;
Figure 5 is a graph that depicts the thin film area per unit cell versus the contact angle for particles having a diameter of 16 micrometers and a fill factor 80%; and
Figure 6 depicts the manufacturing of a porous layer comprised of copper or silica particles.

### DETAILED DESCRIPTION OF THE INVENTION

The disclosure will be described more fully hereinafter with reference to the accompanying drawings, in which exemplary embodiments are shown. As one would realize, the described embodiments may be modified in various different ways, all without departing from the spirit or scope of the invention.

In the drawings, the thickness of layers, films, panels, regions, and the like, are exaggerated for clarity. Like reference numerals designate like elements throughout the specification. It will be understood that when an element such as a layer, film, region, or shell is referred to as being "on" another element, it can be directly on the other element or intervening elements may also be present. In contrast, when an element is referred to as being "directly on" another element, there are no intervening elements present.

It will be understood that, although the terms first, second, third, and the like, may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "lower," "under," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" or "under" relative to other elements or features would then be oriented "upper" or "over" relative to the other elements or features. Thus, the exemplary term "under" can encompass both an orientation of above and below. The device may be otherwise oriented (rotated 90 degrees or at other orientations) and the spatially relative descriptors used herein interpreted accordingly.

Furthermore, in describing the arrangement of components in embodiments of the present disclosure, the terms "upstream" and "downstream" are used. These terms have their ordinary meaning. For example, an "upstream" device as used herein refers to a device producing a fluid output stream that is fed to a "downstream" device. Moreover, the "downstream" device is the device receiving the output from the "upstream" device. However, it will be apparent to those skilled in the art that a device may be both "upstream" and "downstream" of the same device in certain configurations, e.g., a system comprising a recycle loop.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments should not be construed as limited to the particular shapes of regions illustrated herein but are to include deviations in shapes that result, for example, from manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The term "comprising" as used herein may be substituted by "consisting of" or "consisting essentially of'. In addition, the use of the term "about" preceding a numeral is intended to include that numeral. For example, the use of the phrase "about 0.1 to about 1" is intended to mean that both 0.1 and 1 are included in the range. In addition, all numbers and ranges disclosed herein are interchangeable.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Disclosed herein is a heat transfer device (such as, for example, an heat pipe, vapor chamber or thermal ground plane) for thermal applications that have a plurality of different cross-sectional designs along its length, the length being the dimension along the direction in which both heat and mass flow are predominantly directed. The different cross-sectional designs can facilitate an efficient heat flow and mass flow from a first end to a second end of the heat transfer device. In one embodiment, the heat transfer device has a first section having a first cross-sectional design proximately disposed to the first end where heat is introduced into the heat transfer device, a second section having a second cross-sectional design proximately disposed down stream of the first section and a third section having a third cross-sectional design proximately disposed downstream of the second section.

The third section is proximately disposed to the second end of the heat transfer device where the heat is removed from the heat transfer device. The first end and the second end of the heat transfer device are opposedly disposed to each other. Multiple sequences of these sections or two dimensional variations are feasible. If desired, the heat transfer device can have fourth, fifth and sixth sections that have fourth, fifth and sixth cross-sectional designs respectively.

The heat transfer device is an enclosed elongated device that comprises a shell having a porous layer disposed thereon. The pores of the porous layer are completely or partially filled with saturated liquid. Disposed between opposing faces of the porous layer is a region that permits the transport of a vapor. The shell contacts a heat source and a heat sink and is closed, i.e., there is no exchange of matter from outside the shell with that inside the shell. When the heat transfer device contacts a heat source, liquid inside the porous media evaporates and locally vapor is generated, which is transported from the heat source end and transported to the heat sink end, where it condenses on the porous media which releases the heat to the heat sink.

In one embodiment, upon being heated the vapor that is generated travels from the first section to the second section and then to third section. Thus with reference to the vapor, the second section is located downstream of the first section, while the third section is downstream of the second section. The vapor condenses into water in the third section. The water travels back to the first section from the third section. Thus with respect to the water, the second section is located downstream of the third section, while the first section is located downstream of the second section.

In one embodiment, the heat transfer device is a planar, thermal expansion matched heat spreader that is capable of moving heat from multiple sources (e.g., chips) to a remote thermal sink. In one embodiment, the heat transfer device has an effective thermal conductivity that is more than 100 times greater than other comparative commercially available heat transfer device. The heat transfer device is based on a heat pipe architecture where particles of different sizes are selectively arranged in different configurations in the various sections listed above to produce an enhanced heat transport and mass transport.

In an exemplary embodiment, the first section is an evaporator section that contacts the heat source. The first section comprises a porous layer where the particles are arranged to form a first cross-sectional design. In another exemplary embodiment, the second section is a wicking or transport section that comprises a plurality of layers of nanoparticles that are arranged to form a second cross-sectional design, the second cross-sectional design being different from the first cross-sectional design. In yet another exemplary embodiment, the third section is a condenser section that comprises a plurality of layers of nanoparticles that are arranged to form a third cross-sectional design.

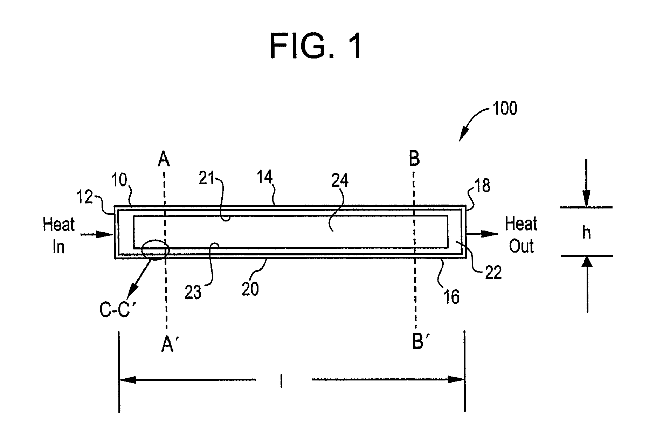

With reference to the Figure 1, the heat transfer device 100 comprises a first section 10 (see portion to the left of section AA' when facing the viewer) disposed proximate to the first end 12. Heat from an external source may be input into the first end 12. A second section 14 (see portion between the section AA' and BB') is disposed downstream (proximate) of the first section 10, while a third section 16 (see portion to the right of section BB' when facing the viewer) is disposed proximate of the second section 12. The third section 16 is disposed proximate to the second end 18 of the heat transfer device 100. Heat is extracted from the second end 18 of the heat transfer device.

As can be seen in the Figure 1, the heat transfer device 100 comprises a shell 20 and one or more porous layers 22 disposed upon the shell. Porous media can exist on either side of the surface. The shell 20 has an inner surface and an outer surface. The porous layer 22 is a porous layer that is disposed on the inner surface of the shell. The porous layer 22 contacts a fluid (e.g., water) that is heated by the heat source to form a saturated vapor. The opposing surfaces 21 and 23 of the porous layer 22 have disposed therebetween a region 24 that permits convection of the saturated vapor from the first end to the second end of the heat transfer device. Porous layer 22 could extend between opposing surfaces 21 and 23 containing passages for vapor transport 24. The second end of the heat transfer device contacts a heat sink. The condensation of the saturated vapor at the second end of the heat transfer device thus facilitates heat transfer from the heat source to the heat sink.

The shell is a three-dimensional device that is closed at all ends. Matter from within the shell is not exchanged with matter that lies outside the shell. In other words, the shell serves as a boundary to prevent matter from the within the shell from diffusing outside the shell and vice-versa. Additionally the shell is evacuated an resides at a pressure less than atmospheric pressure. The shell has disposed on it a porous layer (sometimes called a wick). It is desirable for the material of the shell to have a coefficient of thermal expansion that is similar to those components that it contacts in order to prevent dissimilar expansion. Dissimilar expansion can lead to damage of either the shell or the component that it contacts. The shell can comprise a metal, a ceramic or a polymer depending upon the application.

In an exemplary embodiment, the shell comprises a metal. Examples of suitable metals are copper, aluminum, iron, titanium, tin, tungsten, chromium, or the like, or a combination comprising at least one of the foregoing metals. Examples of combinations of metals include carbon steel, stainless steel, chromalloy, brass, bronze, alnico, duralumin, nambe, silumin, AA-8000, magnalium, β-Al-Mg, ξ'-Al-Pd-Mn, T-Al3Mn, wood's metal (alloy of lead, tin and cadmium), rose metal (alloy of lead and tin), megallium, stellite (alloy of chromium, tungsten and carbon), talonite, vitallium, or the like. Exemplary metals for use in the shell are copper laminates, copper tungsten alloys and copper-molybdenum laminates.

Examples of suitable ceramics are metal oxides, metal borides, metal nitrides, metal carbides, or the like, or a combination comprising at least one of the foregoing ceramics. Examples of suitable metal oxides are silica, titania, zirconia, ceria, alumina, or the like, or a combination comprising at least one of the foregoing oxides. Examples of metal borides, metal nitrides and metal carbides are provided below. An exemplary ceramic is aluminum nitride.

Organic polymers having glass transition temperatures greater than or equal to about 150°C may be used for the shell. Organic polymers that have glass transition temperatures that are lower than room temperature, but which undergo thermal degradation at temperatures greater than or equal to about 100°C may also be used. The organic polymers can be thermoplastics, thermosets, blends of thermoplastics, blends of thermosets, or blends of thermoplastics with thermosets. In one embodiment, the shell can comprise an elastomer having an elastic modulus at room temperature of about 10⁵ to about 10⁹ pascals.

Examples of suitable polymers are polyacetals, polyolefins, polyacrylics, polycarbonates, polystyrenes, polyesters, polyamides, polyamideimides, polyarylates, polyarylsulfones, polyethersulfones, polyphenylene sulfides, polyvinyl chlorides, polysulfones, polyimides, polyetherimides, polytetrafluoroethylenes, polyetherketones, polyether etherketones, polyether ketone ketones, polybenzoxazoles, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polysilazanes, polysiloxanes, polybutadienes, polyisoprenes, polynitriles, or the like, or a combination comprising at least one of the foregoing polymers.

The shell can be a cylinder, a pyramid, a cube, an ellipsoid, a sphere, a rectangular cuboid, a geodesic dome, an n-sided antiprism, a cupola, a rhombohedron, a prism, or the like. A cross-section of the shell can have a variety of different geometries. Examples of suitable geometries are squares, rectangles, circles, ellipses, polygons, or the like, or a combination comprising at least one of the foregoing geometries. An exemplary cross-section is a square or a rectangle.

As shown in the Figure 1, the shell can have a length "1" and a height "h" and a width "w" (not shown). The shell can have a length "1" of about 10 millimeters to about 1 meter. In one embodiment, the shell can have a length "1" of about 30 millimeters (mm) to about 0.75 meter. In another embodiment, the shell can have a length "1" of about 50 millimeters (mm) to about 0.50 meter. In yet another embodiment, the shell can have a length "1" of about 75 millimeters (mm) to about 0.25 meter.

When the shell has a number of sides (e.g., when the cross-section of the shell is a square or a rectangular (4 sides) or a pentagon (5 sides)) the length of the smallest side (measured in a direction perpendicular to the direction in which the length "1" is measured) is greater than or equal to about 100 nanometers. In one embodiment, the distance of the smallest side can be about 200 nanometers to about 20 centimeters. In another embodiment, the distance of the smallest side can be about 500 nanometers to about 10 centimeters. In yet another embodiment, the distance of the smallest side can be about 1,000 nanometers to about 1 centimeter.

When the shell has a circular or an elliptical cross section, the diameter or the minor axis the shell (measured in a direction perpendicular to the direction in which the length "1" is measured) is greater than or equal to about 100 nanometers. In one embodiment, the diameter or the minor axis the shell can be about 200 nanometers to about 20 centimeters. In another embodiment, the diameter or the minor axis the shell can be about 500 nanometers to about 10 centimeters. In yet another embodiment, the diameter or the minor axis the shell can be about 1,000 nanometers to about 1 millimeter.

Thus, for example, with respect to the Figure 1, when the cross-sectional area of the heat transfer device is a square, the sides of the square (e.g., the width (not shown) and the height "h" of the square) can be greater than or equal to about 100 nanometers. In one embodiment, the sides of the square can be about 200 nanometers to about 20 centimeters. In another embodiment, the sides of the square can be about 500 nanometers to about 10 centimeters. In yet another embodiment, the height of the square can be about 1,000 nanometers to about 1 millimeter.

When, for example, the cross-sectional area of the heat transfer device is a rectangle, the smallest side of the rectangle can be greater than or equal to about 100 nanometers. In one embodiment, the smallest side of the rectangle can be about 200 nanometers to about 20 centimeters. In another embodiment, the smallest side of the rectangle can be about 500 nanometers to about 10 centimeters. In yet another embodiment, the smallest side of the rectangle can be about 1,000 nanometers to about 1 millimeter.

The shell can have an aspect ratio of greater than or equal to about 2. The aspect ratio is equal to the length "1" of heat transfer device divided by the largest linear cross-sectional dimension of the heat transfer device measured perpendicular to the length. In one embodiment, the shell can have an aspect ratio of to about 5 to about 10,000. In another embodiment, the shell can have an aspect ratio of to about 10 to about 5,000. In yet another embodiment, the shell can have an aspect ratio of to about 20 to about 1,000.

The porous layer can comprise particles of various sizes and having various surface chemistries. The surface chemistry (e.g., the hydrophobicity or hydrophilicity) of the particles in the porous layer can be also be used to effect heat and mass transfer.

The capillary forces in the pores can be varied with particle size. In general, capillary forces increase with decreasing pore size. Pore sizes decrease with decreasing particle size. The increase in the capillary forces as a result of decrease in particle size restricts mass flow. As the pore size is decreased however, the surface area per unit volume of the particles is increased. With the increase in the surface area of the particles, the available area for the formation of a fluid thin film on the particle surface is increased. A larger surface area permits better heat transfer by evaporation and condensation. It is therefore desirable to balance these competing effects, additionally taking into account any gravitational forces the device may encounter in order to bring about the desired amount of heat transfer and mass transfer to the second section.

In one embodiment, the particle size can be tailored to effect the pore sizes and consequently the mass transfer. The particles can be nanometer-sized particles or micrometer-sized particles. The particles can have average particle sizes of about 10 nanometers to about 100,000 nanometers. In one embodiment, the particles can have average particle sizes of about 100 to about 5,000 nanometers. In another embodiment, the particles can have average particle sizes of about 200 to about 3,000 nanometers. In yet another embodiment, the particles can have average particle sizes of about 300 to about 1,000 nanometers.

The particles can have a unimodal or multimodal particle size distribution. In one embodiment, the particles can have a bimodal size distribution. In another embodiment, the particles can have a trimodal size distribution. Within a particular particle size distribution, it is desirable for the particles to have a polydispersity index of about 1 to about 1.25. In one embodiment, the particles have a polydispersity index of about 1.02 to about 1.15. In another embodiment, the particles have a polydispersity index of about 1.03 to about 1.10.

The contact angle of the particles can be changed by varying the surface chemistry. The surface chemistry of the particles can be varied by coating the particles with materials that are hydrophobic or hydrophilic. In order to render the particles hydrophobic, materials such as polyfluorocarbons, polysiloxanes, trichloromethylsilane, hexamethylenedisilazane, and the like, can be used to coat the particles. The particles can be rendered hydrophilic by coating them with polyamides, polyvinylalcohols, urea, urethanes, and the like. The contact angles of the particles with water can be varied in an amount of about zero degrees to about 120 degrees. In one embodiment, the contact of the particles with water can be varied in an amount of about 5 degrees to about 80 degrees. In another embodiment, the contact angle of the particles with water can be varied in an amount of about 10 degrees to about 50 degrees. Since a lower contact angle represents a larger degree of wetting than a larger contact angle, particles that have lower contact angles assist thin film production on their surfaces and are therefore better for heat transfer purposes.

The porous layer contacts the shell intimately along the inner surface of the shell. The porous layer is of a thickness effective to facilitate the formation of a region between opposing surfaces of the porous layer, where the saturated vapor can be transported from the first end to the second end (or vice versa) of the heat transfer device. In one embodiment, the porous layer has a thickness of about 10 nanometers to about 10 millimeters. In another embodiment, the porous layer has a thickness of about 100 nanometers to about 1 millimeter. In yet another embodiment, the porous layer has a thickness of about 1 micrometer to about 300 micrometers.

The porous layer has a thermal conductivity of about 0.1 to about 2000 watts per meter-kelvin (W/m-K). In one embodiment, the porous layer has a thermal conductivity of about 10 to about 1000 W/m-K. In another embodiment, the porous layer has a thermal conductivity of about 50 to about 500 W/m-K. In yet another embodiment, the porous layer has a thermal conductivity of about 100 to 400 W/m-K.

The porous layer provides for a mass flow rate of about 10⁻⁹ to about 10⁻⁴ kilograms per second (kg/s). In one embodiment, the porous layer provides for a mass flow rate of about 10⁻⁹ to about 10⁻⁵ kg/s. In one embodiment, the porous layer provides for a mass flow rate of about 10⁻⁸ to about 10⁻⁶ kg/s. In another embodiment, the porous layer provides for a mass flow rate of about 10⁻¹⁰ to about 10⁻⁴ kg/s. In an exemplary embodiment, the porous layer has a mass flow rate of about 10⁻⁷ kg/s.

The particles in the porous layer can be arranged in a number of different configurations to achieve a suitable combination of heat transfer and mass transfer.

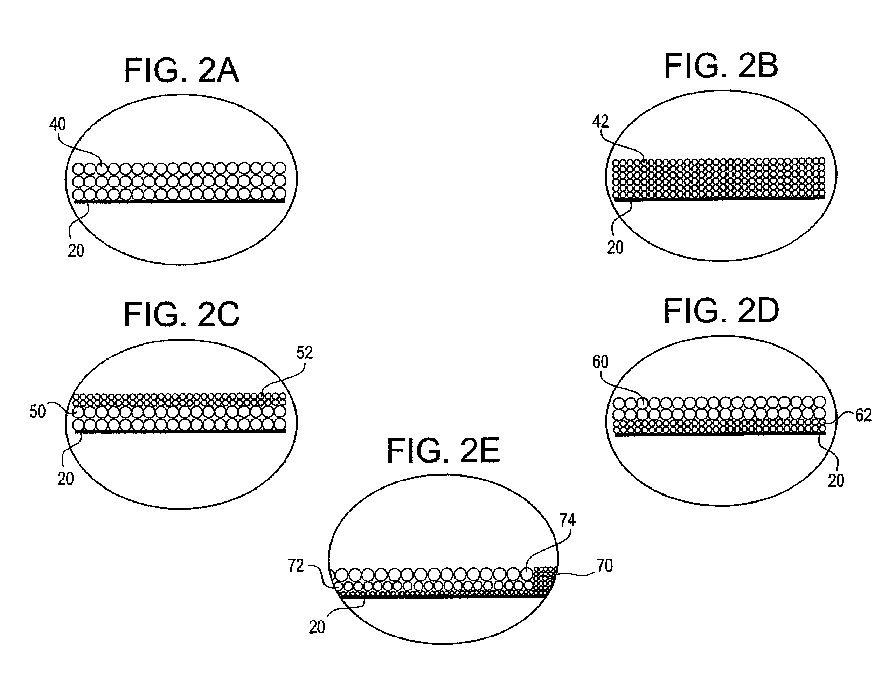

Figure 2 depicts various combinations of particles in the porous layer of the first section. The exemplary views depicted in the Figures 2(a), (b), (c), (d) and (e) are expanded views of the section C-C' taken from the Figure 1. These views are cross-sectional views taken in a direction perpendicular to the length "1" of the heat transfer device at A-A'.

Figures 2(a) and 2(b) are exemplary schematics each of which depict a plurality of particles in the porous layer. The porous layer is disposed on the shell 20 of the heat transfer device 100. The particles of the Figures 2(a) and 2(b) are of a unimodal size distribution, with the particles 40 of the Figure 2(a) having a larger particle size than the particles 42 of the Figure 2(b). The larger particle sizes generally produce large pore sizes than the pore sizes produced by the smaller particles. In general, for capillary driven mass transport in porous media, the smaller the pores the larger the potential capillary forces and the larger the viscous flow resistance. Conversely, the larger the pores the smaller the capillary forces and the viscous flow resistance. To maximize capillary-driven mass transport in uniform porous media these competing effects must be balanced to maximize performance.

In general, for mass transport in porous media, permeability is determined by the pore sizes and porosity of the porous structure. Larger pores facilitate mass transport as larger mass flow rates can be achieved given a fixed pressure difference. As critical heat flux requires the surface to be wetted, sufficient permeability and therefore pore size is required to sustain sufficient mass flow.

In general, for heat transport in uniform porous media, the smaller the particles (and pores) making up the porous media the larger the thin film heat transfer coefficients because of the higher surface area to volume ratios. The larger the particles (and pores) making up the porous media the larger the nucleate boiling heat transfer coefficients because of the lower resistance to venting bubbles that would otherwise conglomerate to form a insulating vapor layers at the critical heat flux.

Figures 2(c) and 2(d) are exemplary depictions of porous layers where the particles have a bimodal distribution. As can be seen in the Figures 2(c) and 2(d), the particles are arranged in a plurality of layers 50, 52. A first layer 52 has particles of a first particle size distribution while a second layer 50 has particles of a second particle size distribution. In the Figure 2(c), the first layer 52 has particles of a smaller particle size disposed upon the second layer 50 of particles that have a larger particle size. The combination of the smaller particle sizes with larger particle sizes can be used to enhance the heat and mass transfer. In particular, the configuration displayed in the Figure 2(c) can be tailored for thin film heat transfer.

The Figure 2(d) depicts an exemplary variation of the porous layers, wherein the first layer 60 has particles of a larger particle size disposed upon a second layer 62 of particles that have a smaller particle size. In one embodiment, the configuration displayed in the Figure 2(d) can be tailored for good nucleate boiling. Thus the configurations displayed in the Figures 2(c) and 2(d) can be selected to produce good heat transfer and good mass transfer in various evaporation regimes.

The Figure 2(e) depicts a plurality of layers of different particle sizes. As can be seen in the Figure 2(e), the porous layer comprises three layers of particles - a first layer 70, a second layer 72 and a third layer 74. The first layer 70 has the smallest particle sizes. Disposed upon the first layer 70 is the second layer 72 of particles whose particles have a larger particle size than those of the first layer 70. Disposed upon the second layer is the third layer 74 of particles whose particles have a larger particle size than those of the second layer 72. The larger particles of the second and the third layers are bounded on both sides by the smaller particles of the first layer. By gradually increasing the particle sizes from the first layer to the third layer, the venting (mass transfer) can be increased toward the surface of the porous layer furthest from the shell, while providing for heat transfer in the immediate vicinity of the shell.

When particles having a unimodal particle size distribution are used, average particle sizes are about 10 nanometers to about 10,000,000 nanometers. When a bimodal or higher distribution of particles are used in the porous layer, the smallest particles have an average particle size of about 10 to about 10,000 nanometers, with larger particles having an average particle size of about 10,001 nanometers to about 100,000 nanometers. If a trimodal particle distribution is used, larger particles having an average particle size of about 100,001 to about 10,000,000 nanometers can be used. Other combinations of particles sizes and particle size ranges may be used if desired.

The porous layer can comprise a metal, a polymer, a ceramic, or a combination comprising at least one of the foregoing metals, polymers or ceramics. In one embodiment, the porous layer generally comprises particles that can exist in the form of agglomerates and aggregates, thus providing a porous layer having a high surface area. An aggregate comprises more than one particle in physical contact with one another, while an agglomerate comprises more than one aggregate in physical contact with one another. In one embodiment, the particles may agglomerate to form a structure with a fractal dimension of about 1 to about 3, i.e., it can be a mass fractal. In another embodiment, the particles may agglomerate to form a structure with a fractal dimension of about 3 to about 4, i.e., it can be a surface fractal. The fractal dimensions can be measured using scattering techniques.

The porous layer can comprise a metal. Examples of metals are transition metals and platinum group metals from the periodic table. Examples of suitable metals are gold, platinum, silver, palladium, copper, aluminum, nickel, cobalt, titanium, tin, or the like, or a combination comprising at least one of the foregoing metals.

The porous layer can comprise a ceramic, such as inorganic oxides, metal oxides, silicates, borides, carbides, nitrides, perovskites and perovskites derivatives, or the like, or a combination comprising at least one of the foregoing. Examples of inorganic oxides include calcium oxide, silicon dioxide, or the like, or a combination comprising at least one of the foregoing inorganic oxides. In one embodiment, the ceramic comprises metal oxides of alkali metals, alkaline earth metals, transition metals, metalloids, poor metals, or the like, or a combination comprising at least one of the foregoing. In one embodiment, the ceramic can be in the form of an aerogel.

Examples of inorganic oxide and/or metal oxides are silicon dioxide, cerium oxide, magnesium oxide, titanium oxide, zinc oxide, copper oxide, cerium oxide, niobium oxide, tantalum oxide, yttrium oxide, zirconium oxide, aluminum oxide (e.g., alumina and/or fumed alumina), CaTiO₃, MgZrSrTiO₆, MgTiO₃, MgAl₂O₄, BaZrO₃, BaSnO₃, BaNb₂O₆, BaTa₂O₆, WO₃, MnO₂, SrZrO₃, SnTiO₄, ZrTiO₄, CaZrO₃, CaSnO₃, CaWO₄, MgTa₂O₆, MgZrO₃, La₂O₃, CaZrO₃, MgSnO₃, MgNb₂O₆, SrNb₂O₆, MgTa₂O₆, Ta₂O₃, or the like, or a combination comprising at least one of the foregoing metal oxides.

Examples of silicates are Na₂SiO₃, LiAlSiO₄, Li₄SiO₄, BaTiSi₃O₉, Al₂Si₂O₇, ZrSiO₄, KAlSi₃O₈, NaAlSi₃O₈, CaAl₂Si₂O₈, CaMgSi₂O₆, Zn₂SiO₄ or the like, or a combination comprising at least one of the foregoing silicates.

Examples of borides are lanthanum boride (LaB₆), cerium boride (CeB₆), strontium boride (SrB₆), aluminum boride, calcium boride (CaB₆), titanium boride (TiB₂), zirconium boride (ZrB₂), vanadium boride (VB₂), tantalum boride (TaB₂), chromium borides (CrB and CrB₂), molybdenum borides (MoB₂, Mo₂B₅ and MoB), tungsten boride (W₂B₅), or the like, or a combination comprising at least one of the foregoing borides.

Examples of carbides are silicon carbide, tungsten carbide, tantalum carbide, iron carbide, titanium carbide, or the like, or a combination comprising at least one of the foregoing carbides.

Examples of nitrides include silicon nitride, boron nitride, titanium nitride, aluminum nitride, molybdenum nitride, or the like, or a combination comprising at least one of the foregoing nitrides.

Examples of perovskites and perovskite derivatives include barium titanate (BaTiO₃), strontium titanate (SrTiO₃), barium strontium titanate, strontium-doped lanthanum manganate, lanthanum aluminum oxides (LaAlO₃), calcium copper titanate

(CaCu₃Ti₄O₁₂), cadmium copper titanate (CdCu₃Ti₄O₁₂), Ca₁₋ₓLaₓMnO₃, (Li, Ti) doped NiO, lanthanum strontium copper oxides (LSCO), yttrium barium copper oxides (YBa₂Cu₃O₇), lead zirconate titanate, lanthanum-modified lead zirconate titanate, or the like, or a combination comprising at least one of the foregoing perovskites and perovskite derivatives.

As noted above, the ceramic particles may comprise nanoparticles. Commercially available examples of nanoparticles that can be used in the composition are calcium oxide commercially available as NANOACTIVE CALCIUM OXIDE^{™} or NANOACTIVE CALCIUM OXIDE PLUS^{™}, cerium oxide commercially available as NANOACTIVE CERIUM OXIDE^{™}, magnesium oxide commercially available as NANOACTIVE MAGNESIUM OXIDE^{™} or NANOACTIVE MAGNESIUM OXIDE PLUS^{™}, titanium oxide commercially available as NANOACTIVE TITANIUM OXIDE^{™}, zinc oxide commercially available as NANOACTIVE ZINC OXIDE^{™}, silicon oxide commercially available as NANOACTIVE SILICON OXIDE^{™}, copper oxide commercially available as NANOACTIVE COPPER OXIDE^{™}, aluminum oxide commercially available as NANOACTIVE ALUMINUM OXIDE^{™} or NANOACTIVE ALUMINUM OXIDE PLUS^{™}, all of which are commercially available from NanoScale Materials Incorporated. Another commercially available set of nanoparticles are aluminum oxide nanoparticles sold as NANODUR^{™} from Nanophase Technologies Corporation.

Polymers that can be used in the porous layers are generally aerogels or xerogels. Examples of polymeric aerogels or xerogels are resorcinol-formaldehyde aerogels or xerogels, phenol-formaldehyde aerogels or xerogels, or the like, or a combination comprising at least one of the foregoing polymeric aerogels.

The porous layer can also comprise carbonaceous materials. Examples of porous layers that are carbonaceous are carbon black coatings, carbon nanotube coatings, carbon aerogel coatings, or the like, or a combination comprising at least one of the foregoing carbonaceous coatings. Carbon aerogels can be obtained by pyrolyzing the aforementioned polymeric aerogels.

In an exemplary embodiment, the porous layer can comprise nanoparticles having any geometry. There is no particular limitation to the shape of the nanoparticles, which may be, for example, spherical, irregular, plate-like or whisker like.

The porous layer can have a surface area of about 50 to about 1,200 square meters per gram (m²/gm). In one embodiment, porous layer can have a surface area of about 100 to about 1,000 square meters per gram (m²/gm). In another embodiment, the porous layer can have a surface area of about 150 to about 800 square meters per gram (m²/gm). In yet another embodiment, the porous layer can have a surface area of about 200 to about 700 square meters per gram (m²/gm).

The porous layer has pore sizes of about 10 to about 10,000,000 nanometers. In one embodiment, the porous layer has pore sizes of about 1,000 to about 1,000,000 nanometers. In another embodiment, the porous layer has pore sizes of about 10,000 to about 100,000 nanometers.

The porous layer has a porosity of about 10 to about 99.9 volume percent, based on the total volume of the coating. In one embodiment, the porous layer has a porosity of about 20 to about 90 volume percent, based on the total volume of the coating. In yet another embodiment, the porous layer has a porosity of about 30 to about 70 volume percent, based on the total volume of the coating.

The porous layer has a thickness of about 5 nanometers to about 10 millimeters. In one embodiment, the porous layer has a thickness of about 5 nanometers to about 5 micrometers. In another embodiment, the porous layer has a thickness of about 75 nanometers to about 20 micrometers. In an exemplary embodiment, the porous layer has a thickness of about 100 nanometers to about 100 micrometer.

With reference now again to the Figure 1, the region 24 is filled with a fluid. A suitable fluid is a saturated vapor. The vapor can comprise water, alcohol, ketones, ether, halogenated solvents, and the like. A list of solvents are provided below. An exemplary saturated vapor comprises water.

In one embodiment, the region 24 can be filled with larger sized particles (not shown) than those used in porous layer. The particles used in the region 24 can have the same composition as the particles used in the porous layer. In one embodiment, the larger sized particles can have average particle size of about 10,000 nanometers to about10,000,000 nanometers. In another embodiment, the larger sized particles can have average particle size of about 100,000 nanometers to about 1,000,000 nanometers.

There are several different methods by which the porous layer can be manufactured. In one embodiment, in one method of manufacturing the porous layer, a slurry comprising the nanoparticles described above and a suitable liquid is disposed upon the shell. The slurry can optionally contain a binder and an acid. The slurry may be disposed upon the shell by spin coating, dip coating, brush painting, spray painting, electrostatic spray painting, or the like, or a combination comprising at least one of the foregoing methods.

The shell with the slurry disposed thereon is then subjected to drying. The liquid from the slurry is evaporated during the drying, leaving behind the porous layer. In one embodiment, this layer may be the first layer of the porous layer. In one embodiment, the drying can be conducted by subjecting the liquid in the slurry to heating causing it to evaporate. The heating can be brought about by conduction, convection and/or radiation. Radiation involving radio-waves, microwaves, or infrared waves can be used.

In one embodiment, a second slurry having particles of different sizes from those of the first slurry can then be disposed upon the first layer to form a second layer. In another embodiment, a third slurry having particles of different sizes from those of the first slurry and/or the second slurry can then be disposed upon the second layer to form the third layer. In this manner, a plurality of layers can be disposed on the shell to form the porous layer.

The particles are generally present in an amount of about 0.0001 volume percent (vol%) to about 60 vol%, based upon the total volume of the slurry. In another embodiment, the particles are present in an amount of about 0.001 vol% to about 0.1 vol%, based upon the total volume of the slurry.

The liquid can be present in the slurry in an amount of about 30 to about 99.9 vol%. In one embodiment, the liquid can be present in the slurry in an amount of about 60 to about 99 vol%. In another embodiment, the liquid can be present in the slurry in an amount of about 70 to about 98 vol%.

In another embodiment, pertaining to the manufacturing of the porous layer, a reactive solution comprising a particle precursor such as an inorganic alkoxide is mixed in a vessel with a suitable solvent, a modifier, and an optional suitable surfactant. The reactive solution, which is initially in the form of a sol is converted to a gel by the sol gel process. The reactive solution in the form of a sol is then disposed on the shell. In one embodiment, the gel disposed on the shell is optionally washed, dried and calcined to yield a nanoporous composition that is disposed upon the shell. In another embodiment, the solvent present in the gel is exchanged with a supercritical fluid (e.g., supercritical carbon dioxide) to yield an aerogel. In yet another embodiment, the gel is treated with an agent such as trimethylchlorosilane, hexamethylenedisilazane, or the like, or combinations comprising at least one of trimethylchlorosilane or hexamethylenedisilazane to yield an aerogel.

Examples of suitable inorganic alkoxides are tetraethylorthosilicate, tetramethylorthosilicate, aluminum isopropoxide, aluminum tributoxide, aluminum ethoxide, aluminum-tri-sec-butoxide, aluminum tert-butoxide, antimony(III) ethoxide, antimony(III) isopropoxide, antimony(III) methoxide, antimony(III) propoxide, barium isopropoxide, calcium isopropoxide, calcium methoxide, chlorotriisopropoxytitanium, magnesium di-tert-butoxide, magnesium ethoxide, magnesium methoxide, strontium isopropoxide, tantalum(V) butoxide, tantalum(V) ethoxide, tantalum(V) ethoxide, tantalum(V) methoxide, tin(IV) tert-butoxide, diisopropoxytitanium bis(acetylacetonate) solution, titanium(IV) (triethanolaminato)isopropoxide solution, titanium(IV) 2-ethylhexyloxide, titanium(IV) bis(ethyl acetoacetato)diisopropoxide, titanium(IV) butoxide, titanium(IV) butoxide, titanium(IV) diisopropoxidebis(2,2,6,6-tetramethyl-3,5-heptanedionate), titanium(IV) ethoxide, titanium(IV) isopropoxide, titanium(IV) methoxide, titanium(IV) tert-butoxide, vanadium(V) oxytriethoxide, vanadium(V) oxytriisopropoxide, yttrium(III) butoxide, yttrium(III) isopropoxide, zirconium(IV) bis(diethyl citrato)dipropoxide, zirconium(IV) butoxide, zirconium(IV) diisopropoxidebis(2,2,6,6-tetramethyl-3,5-heptanedionate), zirconium(IV) ethoxide, zirconium(IV) isopropoxide zirconium(IV) tert-butoxide, zirconium(IV) tert-butoxide, or the like, or a combination comprising at least one of the foregoing inorganic alkoxides. Exemplary inorganic alkoxides are tetraethylorthosilicate or aluminum sec-butoxide.

The reactive solution generally contains an inorganic alkoxide in an amount of about 1 to about 50 wt%, based upon the weight of the reactive solution. In one embodiment, the reactive solution generally contains an inorganic alkoxide in an amount of about 5 to about 20 wt%, based upon the weight of the reactive solution.

Solvents that are used may be aprotic polar solvents, polar protic solvents, non-polar solvents Examples of aprotic polar solvents are propylene carbonate, ethylene carbonate, butyrolactone, acetonitrile, benzonitrile, nitromethane, nitrobenzene, sulfolane, dimethylformamide, N- methylpyrrolidone, or the like, or combinations comprising at least one of the foregoing aprotic polar solvents. Examples of polar protic solvents are water, methanol, acetonitrile, nitromethane, ethanol, propanol, isopropanol, butanol, or the like, or combinations comprising at least one of the foregoing polar protic solvents. Examples of non polar solvents include benzene, toluene, methylene chloride, carbon tetrachloride, hexane, diethyl ether, tetrahydrofuran, or the like, or combinations comprising at least one of the foregoing non polar solvents. Co-solvents may also be used. Ionic liquids may also be utilized as solvents during the gelation. An exemplary solvent is ethanol.

Solvents are generally added in an amount of about 0.5 wt% to about 300 wt%, specifically about 1 to about 200 wt%, more specifically about 70 to about 100 wt%, based on the total weight of the reactive solution.

The modifiers may control the hydrolysis kinetics of the inorganic alkoxides. Examples of suitable modifiers are ethyl acetoacetate, ethylene glycol, or the like, or a combination comprising at least one of the foregoing modifiers. The reactive solution generally contains the modifier in an amount of about 0.1 to about 5 wt%, based upon the weight of the reactive solution.

The surfactants are optional and can be anionic surfactants, cationic surfactants, nonionic surfactants, zwitterionic surfactants, or a combination comprising at least one of the foregoing surfactants. The surfactants serve as templates and facilitate the production of shells containing directionally aligned tubular mesochannels forms. The reactive solution generally contains the surfactant in an amount of about 0.1 to about 5 wt%, based upon the weight of the reactive solution. An exemplary surfactant is octylphenol ethoxylate commercially available as TRITON X 114^{®}.

An acid catalyst or a basic catalyst may be used to promote gelation of the metal alkoxide. Acid catalysts (having a pH of about 1 to about 6) generally promote ramified porous structures, while basic catalysts (having a pH of about 8 to about 14) promote compact porous structures. Acid catalysts generally promote the formation of mass fractals having fractal dimensions from about 1 to about 3, while basic catalysts generally promote the formation of surface fractals having fractal dimensions of about 3 to about 4.

In yet another embodiment, pertaining to the manufacturing of the porous layer, a reactive solution comprising a particle precursor such as an inorganic alkoxide is mixed in a vessel with a suitable solvent, metal particles, a modifier, and an optional suitable surfactant. The sol with the metal particles is disposed on the shell. As noted above, the reactive solution, which is initially in the form of a sol is converted to a gel by the sol gel process. The gel holds the metal particles together to form a composite. Following gelation, the composite is annealed at an elevated temperature to evaporate the solvent. The gel may then be fired to convert the gel to a glass. The porous layer thus comprises metal particles bound together by a glass.

In an exemplary embodiment, the shell with the porous layer disposed thereon is part of a heat transfer device. The heat transfer device may be used in electronic devices, in nuclear facilities, as insulation on pipes in chemical plants or in supercomputers, or the like.

The following examples, which are meant to be exemplary, not limiting, illustrate compositions and methods of manufacturing of some of the porous layers described herein as well as their properties when used in a heat transfer device.

### EXAMPLES

### Example 1

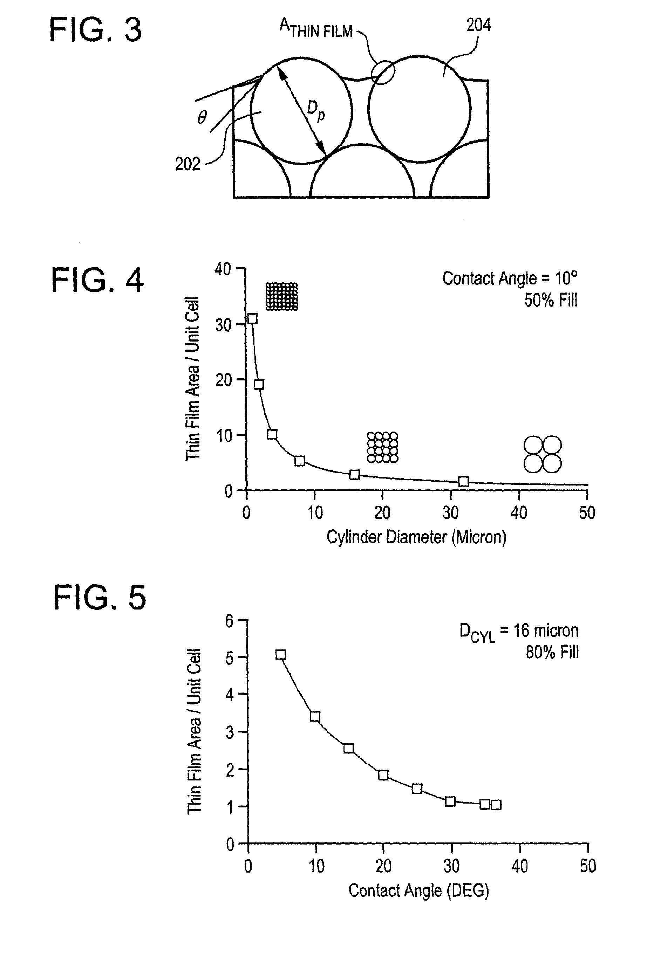

This example is conducted to demonstrate the properties of contact angle and its effect on film thickness on particles that are used to form the porous layer. The porous layer comprises particles as shown in the Figure 3. The Figure 3 depicts a unit cell formed by the particles. With respect to the Figure 3, the unit cell comprises two particles 202 and 204. The particles have a diameter Dₚ and a contact angle "θ" that may be varied with tailored coatings.

Upon contact the fluid spreads over the particles in the porous layer to form a film. The thickness of the film depends upon the pore sizes and the contact angle of the particle with the fluid.

Figure 4 is a graph that depicts a calculated geometric thin film area per unit cell at a contact angle of 10 degrees and a fill factor, defined to be the ratio of the liquid area to total area per unit cell, of 50%. From the Figure 4 it can be seen that the thin film area increases rapidly as particle size decreases. As the particle size increases into the micrometer range from the nanometer range, it can be seen that the thin film area plateau.

Figure 5 is a graph that depicts a calculated geometric thin film area per unit cell versus the contact angle for particles having a radius of 8 micrometers. The fill factor is 80%. As can be seen from the Figure 5, as the contact angle is decreased the thin film area increases.

The above results demonstrate that by using smaller particles the thin film area can be increased. Similar results can be obtained by decreasing the contact angle.

The results also show that by using particles having a variety of different sizes, a desirable mass flow and a desirable heat flow can be achieved in the heat transfer device.

### Example 2

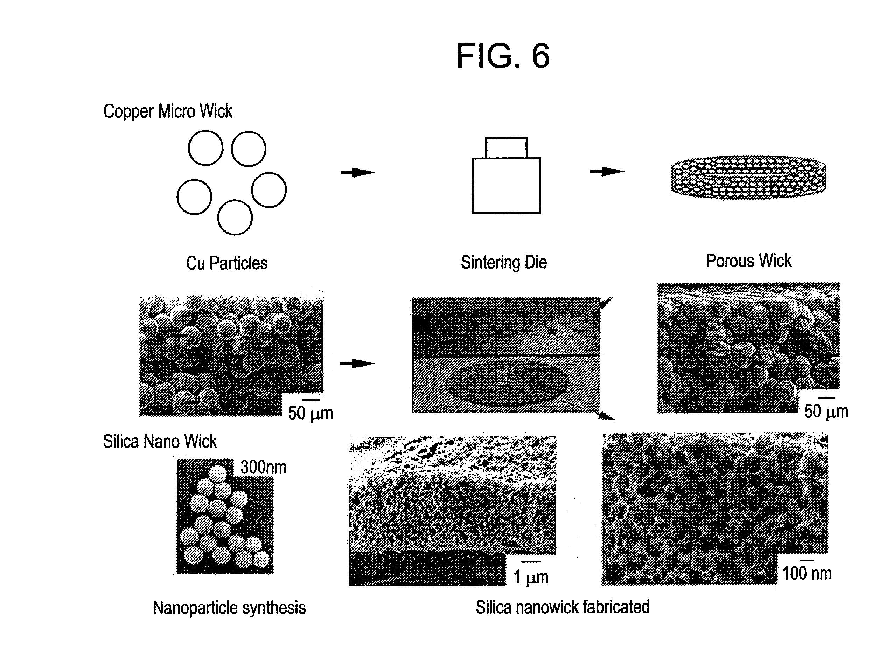

This example demonstrates the formation of a porous layer comprising copper particles. Copper particles having an average particle size of 50 micrometers and a unimodal particle size distribution with a polydispersity index of about 1.15. The Figure 6 depicts the manufacturing of a porous layer that comprises copper particles. The copper particles were pre-pressurized in a die at -22 kilo pounds per square inch (Kpsi), and then sintered between 850 to 950°C for 6 hours. Then the copper porous layer in an amount of ∼3 grams was then coated with ∼0.03 grams of silica. The silica was added via chemical vapor deposition, during which SiCl₄ gas was passed across the surfaces of the copper particles via a nitrogen carrying gas. The SiCl₄ condenses to form a SiO₂ network on the particle surfaces through hydrolization. The contact angle of the SiO₂ coated copper particles is less than 5 degrees after the coating. It is to be noted that the sintering to form copper layer conducted prior to silica formation.

### Example 3

This example demonstrates the manufacturing of a porous layer that comprises silica nanoparticles. The silica nanoparticles like the copper particles in Example 2, have a unimodal particle size distribution with a polydispersity index of about 1. The silica nanoparticles have a particle size diameter of about 300 nanometers. The silica particles were dispersed in a volatile solvent, for example, isopropanol, with a concentration of up to 30 weight percent. The solution was spray coated on a silicon substrate and sintered at 900°C for 6 hours in a vacuum oven.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention.

Various aspects of the present invention are defined in the following clauses:
1. A heat transfer device comprising:
   a shell; the shell being an enclosure that prevents matter from within the shell from being exchanged with matter outside the shell; the shell having an outer surface and an inner surface; and
   a porous layer disposed on the inner surface of the shell; the porous layer having a thickness effective to enclose a region between opposing faces; the region providing a passage for the transport of a fluid; the porous layer having a thermal conductivity of about 0.1 to about 2000 watts per meter-Kelvin and a mass flow rate of about 10⁻⁹ to about 10⁻⁴ kilograms per second.
2. The heat transfer device of Clause 1, having a plurality of different cross-sectional designs along its length; the length being the dimension along the direction in which both heat and mass flow are predominantly directed.
3. The heat transfer device of Clause 1 or Clause 2, where the heat transfer device has a first section having a first cross-sectional design proximately disposed to a first end of the heat transfer device where heat is introduced into the heat transfer device, a second section having a second cross-sectional design proximately disposed to the first section and a third section having a third cross-sectional design proximately disposed to the second section; where the third section is proximately disposed to the second end of the heat transfer device; the heat being removed from the second end of the heat transfer device.
4. The heat transfer device of Clause 3, where the first cross-sectional design is different from the second cross-sectional design or the third cross-sectional design.
5. The heat transfer device of Clause 3, where the second cross-sectional design is different from the third cross-sectional design.
6. The heat transfer device of any preceding Clause, where the shell has a height of about 100 nanometers to about 20 centimeters.
7. The heat transfer device of any preceding Clause, where the heat transfer device contacts a heat source at its first end and a heat sink at its second end.
8. The heat transfer device of any preceding Clause, where the fluid is in a saturated form.
9. The heat transfer device of any preceding Clause, where the heat transfer device recirculates the fluid.
10. The heat transfer device of any preceding Clause, where the shell comprises a metal, a ceramic, a polymer, or a combination thereof.
11. The heat transfer device of Clause, where the shell is a cylinder, a pyramid, a cube, an ellipsoid, a sphere, a rectangular cuboid, a geodesic dome, an n-sided antiprism, a cupola, a rhombohedron or a prism.
12. The heat transfer device of any preceding Clause, where the shell has an aspect ratio of about 5 to about 10,000.
13. The heat transfer device of any preceding Clause, where one or more porous layers comprise particles having average particle sizes of about 10 nanometers to about 10,000,000 nanometers.
14. The heat transfer device of any preceding Clause, where the porous layer comprises particles arranged in a plurality of layers.
15. The heat transfer device of any preceding Clause, where the porous layer comprises a first layer having particles of a first particle size distribution and a second layer having particles of a second particle size distribution; the second layer being disposed upon the first layer.
16. The heat transfer device of Clause 15, where the second layer has particles that have a larger particle size larger than those of the first layer; and where the first layer has a unimodal particle size distribution.
17. The heat transfer device of Clause 15, where the second layer has particles that have a larger particle size smaller than those of the first layer.
18. The heat transfer device of any of Clauses 15 to 17, where the porous layer further comprises a third layer having particles of a third particle size distribution; the third layer being disposed upon the second layer; third particle size distribution being different from the second particle size distribution and the first particle size distribution.
19. The heat transfer device of any of Clauses 15 to 18, where the porous layer is bounded on its sides by particles having the first particle size distribution.
20. The heat transfer device of any of Clauses 15 to 19, where the first particle size distribution comprises particles having an average particle size of about 10 to about 10,000 nanometers; the second particle size distribution has particles having an average particle size of about 10,001 nanometers to about 100,000 nanometers and the third particle size distribution has particles having an average particle size of about 100,001 to about 10,000,000 nanometers.
21. The heat transfer device of any preceding Clause, where a particle of the porous layer has a contact angle with water of about zero degrees to about 120 degrees.
22. The heat transfer device of any preceding Clause, where the fluid is water, alcohol, ketones, or a combination comprising at least one of the foregoing fluids.
23. The heat transfer device of any preceding Clause, where the fluid is saturated water.
24. The heat transfer device of any preceding Clause, where the porous layer has pore sizes of about 10 to about 10,000,000 nanometers and where the porous layer has a porosity of about 10 to about 90 volume percent, based on the total volume of the layer.
25. The heat transfer device of any preceding Clause, where the particles comprise copper.
26. The heat transfer device of any preceding Clause, where the particles are coated with silica.
27. The heat transfer device of any preceding Clause, where the particles are coated with a metal oxide.
28. The heat transfer device of any preceding Clause, wherein the region enclosed between the opposing surfaces of the porous layer is filled with large particles having an average particle size of about 10,000 nanometers to about 10,000,000 nanometers.
29. A method comprising:
   disposing a slurry upon a substrate; the slurry comprising a liquid and about 0.0001 to about 60 volume percent of nanoparticles, based upon the total volume of the slurry;
      evaporating the liquid from the substrate to form a porous layer having a thickness of about 10 nanometers to about 10,000,000 nanometers upon the substrate; and forming the substrate into a shell; the shell being an enclosure that prevents matter from within the shell from being exchanged with matter outside the shell; the porous layer being disposed upon an inner surface of the shell.
30. The method of Clause 29, where the evaporating is brought about by heating the liquid.
31. The method of Clause 29 or Clause 30, where the disposing of the slurry upon the substrate is accomplished by spin coating, dip coating, spray painting, electrostatic spray painting or dip coating.
32. An article manufactured by the method of any of Clauses 29 to 31.
33. The article of Clause 32, where the article is a pipe, a power electronic module, a magnetic resonance imaging gradient driver or a nuclear fuel rod.
34. A method comprising:
   contacting a first end of an heat transfer device with a source of heat; the heat transfer device comprising:
      a shell; the shell being an enclosure that prevents matter from within the shell from being exchanged with matter outside the shell; the shell having an outer surface and an inner surface; and
      a porous layer disposed on the inner surface of the shell; the porous layer having a thickness effective to enclose a region between opposing faces; the region providing a passage for the transport of a fluid; the porous layer having a thermal conductivity of about 0.1 to about 2000 watts per meter-Kelvin and a mass flow rate of about 10⁻⁹ to about 10⁻⁴ kilograms per second;
      evaporating a fluid that is disposed in the porous layer; and
      promoting a flow of the fluid to a second end of the heat transfer device; the second end of the heat transfer device contacting a heat sink.
35. The method of Clause 34, where the first end is opposedly disposed to the second end.
36. The method of Clause 34 or Clause 35, further comprising recycling the fluid from the second end of the heat transfer device to the first end.

## Claims

1. A heat transfer device (100) comprising:
a shell (20); the shell (20) being an enclosure that prevents matter from within the shell (20) from being exchanged with matter outside the shell (20); the shell (20) having an outer surface and an inner surface; and
a porous layer disposed on the inner surface of the shell (20); the porous layer having a thickness effective to enclose a region (24) between opposing faces (21 and 23); the region (24) providing a passage for the transport of a fluid; the porous layer having a thermal conductivity of about 0.1 to about 2000 watts per meter-Kelvin and a mass flow rate of about 10⁻⁹ to about 10⁻⁴ kilograms per second.

2. The heat transfer device (100) of Claim 1, having a plurality of different cross-sectional designs along its length; the length being the dimension along the direction in which both heat and mass flow are predominantly directed.

3. The heat transfer device (100) of any one of Claims 1 or 2, where the heat transfer device (100) has a first section (10) having a first cross-sectional design proximately disposed to a first end of the heat transfer device (100) where heat is introduced into the heat transfer device (100), a second section (14) having a second cross-sectional design proximately disposed to the first section (10) and a third section (16) having a third cross-sectional design proximately disposed to the second section (14); where the third section (16) is proximately disposed to the second end (18) of the heat transfer device (100); the heat being removed from the second end (18) of the heat transfer device (100).

4. The heat transfer device (100) of any one of Claims 1 through 3, where the first cross-sectional design is different from the second cross-sectional design or the third cross-sectional design.

5. The heat transfer device (100) of Claim 3, where the second cross-sectional design is different from the third cross-sectional design.

6. The heat transfer device (100) of any one of Claims 1 through 5, where the heat transfer device (100) contacts a heat source at its first end and a heat sink at its second end (18).

7. The heat transfer device (100) of any one of Claims 1 through 6, where the heat transfer device (100) recirculates the fluid.

8. The heat transfer device (100) of any one of Claims 1 through 7, where the porous layer comprises particles arranged in a plurality of layers.

9. The heat transfer device (100) of Claim 1, where the porous layer comprises a first layer having particles of a first particle size distribution and a second layer having particles of a second particle size distribution; the second layer being disposed upon the first layer.

10. A method comprising:
disposing a slurry upon a substrate; the slurry comprising a liquid and about 0.0001 to about 60 volume percent of nanoparticles, based upon the total volume of the slurry;
evaporating the liquid from the substrate to form a porous layer having a thickness of about 10 nanometers to about 10,000,000 nanometers upon the substrate; and
forming the substrate into a shell (20); the shell (20) being an enclosure that prevents matter from within the shell (20) from being exchanged with matter outside the shell (20); the porous layer being disposed upon an inner surface of the shell (20).

11. The method of Claim 10, where the evaporating is brought about by heating the liquid.

12. An article manufactured by the method of any one of Claims 10 or 11.

13. A method comprising:
contacting a first end (12) of an heat transfer device (100) with a source of heat; the heat transfer device (100) comprising:
a shell (20); the shell (20) being an enclosure that prevents matter from within the shell (20) from being exchanged with matter outside the shell (20); the shell (20) having an outer surface and an inner surface; and
a porous layer disposed on the inner surface of the shell (20); the porous layer having a thickness effective to enclose a region (24) between opposing faces (21 and 23); the region (24) providing a passage for the transport of a fluid; the porous layer having a thermal conductivity of about 0.1 to about 2000 watts per meter-Kelvin and a mass flow rate of about 10⁻⁹ to about 10⁻⁴ kilograms per second;
evaporating a fluid that is disposed in the porous layer; and
promoting a flow of the fluid to a second end (18) of the heat transfer device (100); the second end (18) of the heat transfer device (100) contacting a heat sink.

14. The method of Claim 13, further comprising recycling the fluid from the second end (18) of the heat transfer device (100) to the first end.
